# EUROPEAN PATENT SPECIFICATION

(11) **EP 1 449 268 B1**
(45) Date of publication and mention of the grant of the patent: **20.04.2011**
(21) Application number: 02803970.9
(22) Date of filing: 01.11.2002
(51) Int. Cl.: H01L 41/09

(54) **RADIAL POWER MEGASONIC TRANSDUCER**
RADIALLEISTUNGS-MEGASONIC-WANDLER
TRANSDUCTEUR MEGASONIQUE A PUISSANCE RADIALE

(30) Priority: 02.11.2001 US 350206 P
(43) Date of publication of application: 25.08.2004
(73) Proprietor: Product Systems Incorporated, Campbell, CA 95008 (US)
(72) Inventor: BECK, Mark, J., Los Gatos, CA 95030 (US); VENNERBECK, Richard, B., Los Gatos, CA 95033 (US); LILLARD, Raymond, Y., Redwood City, CA 94061 (US); LIEBSCHER, Eric, G., San Jose, CA 95123 (US)
(74) Representative: Howe, Steven
(86) International application number: PCT/US2002/035044
(87) International publication number: WO 2003/047306

(56) References cited:
- JP-A- 1 209 962
- US-A- 2 485 722
- US-A- 5 980 647
- US-A- 6 021 785
- US-A- 6 021 789
- US-A- 6 039 059
- US-A1- 2002 153 806
- US-B1- 6 222 305
- US-B1- 6 313 567
- US-B2- 6 464 561

## Description

### TECHNICAL FIELD

The present invention relates to transducers that generate acoustic energy in the frequency range around one megahertz and more particularly to a system that delivers a uniform amount of acoustic energy to the surface of a rotating circular object.

### BACKGROUND INFORMATION

It is well-known that sound waves in the frequency range of 0.4 to 2.0 megahertz (MHz) can be transmitted into liquids and used to clean particulate matter from damage sensitive substrates. Since this frequency range is predominantly near the megahertz range, the cleaning process is commonly referred to as megasonic cleaning. Among the items that can be cleaned with this process are semiconductor wafers in various stages of the semiconductor device manufacturing process, disk drive media, including compact disks and optical disks, flat panel displays and other sensitive substrates.

Megasonic acoustic energy is generally created by exciting a crystal with radio frequency AC voltage. The acoustic energy generated by the crystal is passed through an energy transmitting member (a resonator) and into a cleaning fluid. Frequently, the energy transmitting member is a wall of the vessel that holds the cleaning fluid, and a plurality of objects are placed in the vessel for cleaning. For example, U.S. Pat. No. 5,355,048, discloses a megasonic transducer comprised of a piezoelectric crystal attached to a quartz window by several attachment layers. The megasonic transducer operates at approximately 850 KHz. Similarly, U.S. Pat. No. 4,804,007 discloses a megasonic transducer in which energy transmitting members comprised of quartz, sapphire, boron nitride, stainless steel or tantalum are glued to a piezoelectric crystal using epoxy.

It is also known that megasonic cleaning systems can be used to clean single objects, such as individual semiconductor wafers. For example, U.S. Pat. No. 6,021,785 discloses the use of a small ultrasonic transmitter positioned horizontally adjacent to the surface of a rotating wafer. A stream of water is ejected onto the surface of the wafer and used to both couple the acoustic energy to the surface of the disk for sonic cleaning and to carry away dislodged particles. Similarly, U.S. Pat. No. 6,039,059 discloses the use of a solid cylindrically-shaped probe that is placed close to a surface of a wafer while cleaning fluid is sprayed onto the wafer and megasonic energy is used to excite the probe. In another example, U.S. Pat. No. 6,021,789 discloses a single wafer cleaning system that uses a plurality of transducers arranged in a line. A liquid is applied to a surface of the wafer and the transducers are operated so as to produce a progressive megasonic wave that carries dislodged particles out to the edge of the wafer.

Prior art document US5980647 describes a cleaning device which compensates for an increase in linear velocity along the radius of the rotating object to be cleaned by providing suitably driven means for moving the housing across the object.

### SUMMARY OF THE INVENTION

Briefly, the present invention is a transducer that delivers an approximately uniform amount of acoustic energy to every point on the surface of a rotating circular object. The transducer comprises a piezoelectric crystal bonded to a resonator. Electrically conductive layers on either side of the crystal are used to create an electric field which drives the crystal. Preferably, the transducer generates acoustic energy in the frequency range of 0.4 to 2.0 MHz.

In one embodiment, the crystal in the transducer is wedge shaped so that the surface area of the crystal increases as the radius of the rotated object increases. This means that the amount of acoustic energy delivered to the object increases with increasing radius. However, since the frequency with which a region of the object moves under the transducer is varies inversely with the radius, the total amount of acoustic energy delivered to each unit of surface area on the surface of the object is the same. This is useful in situations where the acoustic energy is used to assist some type of chemical reaction occurring on the surface of the object, and it is desired to have the chemical reaction proceed uniformly over the whole surface.

In another embodiment, the crystal has a rectangular shape, but the electrically conductive layers on either side of the crystal are given the wedge shape. This causes the crystal to deliver an amount of acoustic energy to the object that increases with increasing radius, just as if the crystal itself had the wedge shape.

### BRIEF DESCRIPTION OF THE DRAWINGS

Fig. 1 is a side view of the acoustic transducer according to the present invention;
Fig. 2 is a cross-sectional view of the acoustic transducer taken along the line 2-2 of Fig. 1;
Fig. 3 is a schematic cross-sectional view of an acoustic transducer according to the present invention;

Fig 4 is a schematic top view of a wedge-shaped crystal according to the present invention;
Fig 5 is a schematic top view of the acoustic transducer according to the present invention;
Fig 6 is a schematic isometric view of the acoustic transducer according to the present invention;
Fig 7 is a schematic top view of the acoustic transducer according to the present invention;
Fig 8 is a schematic top view of an acoustic transducer,
Fig 9 is a schematic top view of the acoustic transducer according to the present invention;
Fig 10 is a schematic top view of the acoustic transducer according to the present invention; and
Fig 11 is a schematic top view of the acoustic transducer according to the present invention.

### DESCRIPTION OF THE PREFERRED EMBODIMENTS

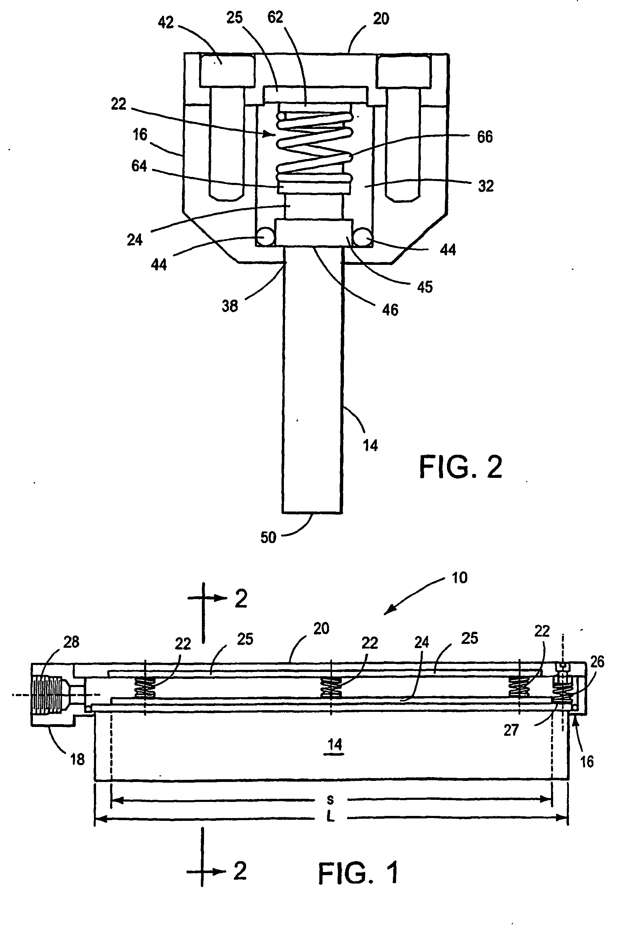

Fig. 1 illustrates an acoustic transducer 10 comprises of a resonator 14 and a transducer housing 16. The housing 16 comprises a body 18 and a cover plate 20. In the preferred embodiment, the housing 16 is made from stainless steel, but other materials such as plastics, ceramics, quartz or aluminum can be used. In a representative configuration, the resonator has a length "L". A plurality of first spring connectors 22 are positioned between a crystal 24 and a printed circuit board (PCB) 25. One or more second spring connectors 26 contact a step region 27. A threaded aperture 28 in an end of the housing 16 is sized to accept a standard BNC connector. Fig. 2 illustrates that the body 18 includes a cavity 32 which holds one or more piezoelectric crystals 24. The resonator 14 extends through a slot 38 and up into the body 18 where it is attached to the crystal 24. The cover plate 20 is attached to the body 18 by attachment means 42, such as screws, bolts or other means, so as to form a liquid tight seal over the cavity 32. Preferably, the fit between the resonator 14 the slot 38 is tight enough to prevent liquid from getting into the cavity 32 through the slot 38. A gasket 44 functions to seal the cavity 32 from moisture, and also prevents any contaminants inside the cavity 32 from escaping. In some embodiments, a lip 45 is formed in the resonator 14 to help in sealing the cavity 32.

The resonator 14 includes a proximal end 46 and a distal end 50. The first spring connector 22 is positioned between the crystal 24 and the PCB 25. The spring connector 22 comprises a base button 62 and a contact button 64 with a spring 66 positioned between the buttons 62 and 64. The spring connector 22 is used to make electrical contact with the crystal 24 as is explained in more detail later.

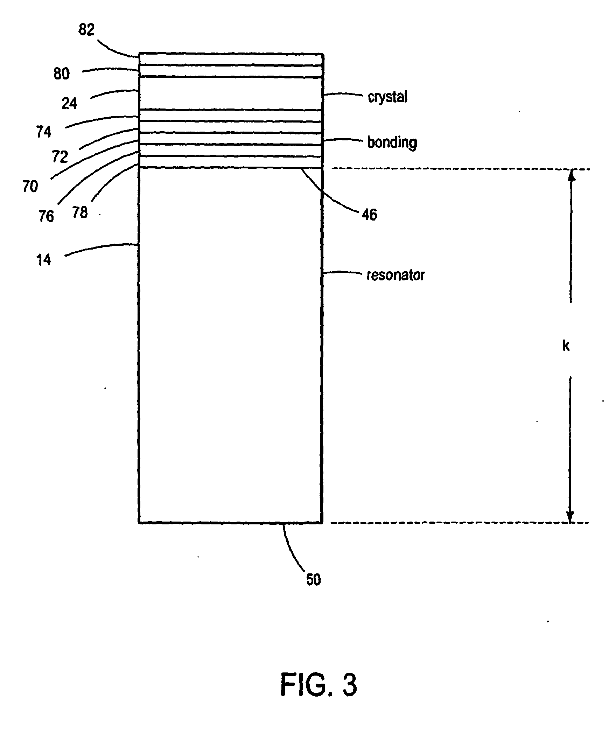

Fig. 3 shows that the resonator 14 is connected to the crystal 24 by a plurality of layers (not to scale). In one embodiment, the crystal 24 is connected to a bonding layer 70 by a first wetting layer 72 and a first adhesion layer 74. The first wetting layer 72 is positioned closest to the bonding layer 70 and the first adhesion layer 74 is positioned closest to the crystal 24. A second wetting layer 76 and a second adhesion layer 78 are positioned between the bonding layer 70 and the resonator 14. The second wetting layer 76 is positioned closest to the bonding layer 70 and the second adhesion layer 78 is positioned closest to the resonator 14. A third adhesion layer 80 is positioned on the opposite side of the crystal 24 from the first adhesion layer 74, and a metal layer 82 is positioned on the third adhesion layer 80.

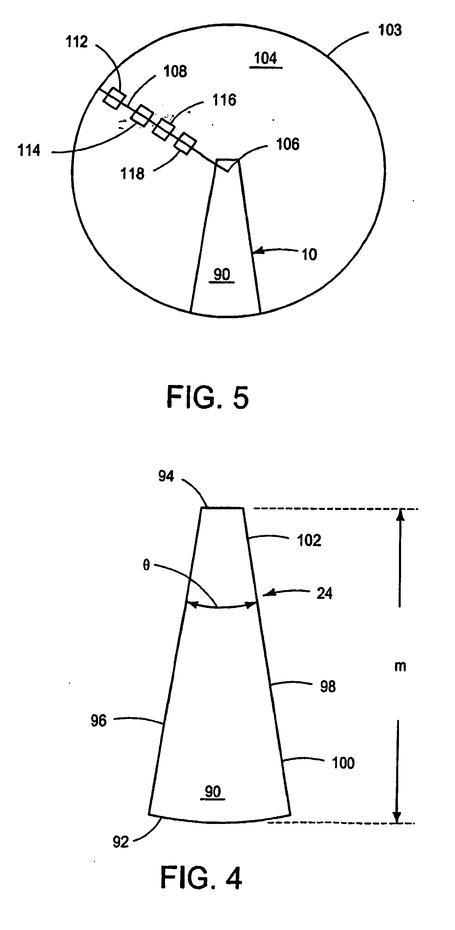

In Fig. 3, the bonding layer 70 may comprise a solder-like material, such as indium, tin, alloys of indium or alloys of tin. Pure indium works particularly well as the bonding layer 70. The composition and purpose of the other layers shown in Fig. 3 are the same as the layers shown in Fig. 5 of U.S. Pat. No. 6,222,305. Specifically, the first and second wetting layers 72 and 76, may comprise silver and each have a thickness of approximately 5000 Å. However, other metals and/or thicknesses could be used for the wetting layers. The function of the wetting layers 72 and 76 is to provide a wetting surface for the molten indium (or tin) in the bonding layer 70, meaning that the wetting layers help the bonding layer 70 adhere to the first adhesion layer 74 and the second adhesion layer 78, respectively.

In one embodiment, the first, second and third adhesion layers 74, 78 and 80, each comprise an approximately 5000 Å thick layer of an alloy comprised of chrome and a nickel copper alloy. For example, the layers 74, 78 and 80 may be comprised of 50% chrome and 50% nickel copper alloy. Acceptable nickel copper alloys include the alloys marketed under the trademarks Nickel 400™ or MONEL™. Nickel 400™ and MONEL™ are copper nickel alloys comprised of 32% copper and 68% nickel. However, other materials and/or thicknesses could also be used as the adhesion layers 74, 78 and 80. For example, any or all of the layers 74, 78 and 80 may comprise chromium, including a chromium nickel alloy. The layer 80 is optional and can be eliminated completely. The layer 82 is preferably silver, but may comprise other conductive metals, including nickel or silver alloys.

In the preferred embodiment, the crystal 24 is a piezoelectric crystal such as a crystal comprised of lead zirconate titanate (PZT). However, many other piezoelectric materials such as barium titanate, quartz or polyvinylidene fluoride resin (PVDF), may be used as is well-known in the art. Preferably, the crystal 24 is capable of generating acoustic energy in the frequency range of 0.4 to 2.0 MHz.

The transducer 10 is constructed using the basic technique described in U.S. Pat. No. 6,222,305. If tin is used as the bonding layer 70, the higher melting point of tin must be taken into consideration.

Depending upon the requirements of a particular cleaning task, the composition of the resonator 14 is selected from a group of chemically inert materials. For example, inert materials that work well as the resonator 14 include sapphire, quartz, silicon carbide, silicon nitride, ceramics, stainless steel and aluminum. Additionally, the resonator 14 can be made chemically inert by coating a non-inert material with a chemically inert material such as Teflon™, Halar™, Kynar™ or PFA. Chemical inertness is desired because it is unacceptable for the resonator 14 to chemically react with the cleaning fluid. Thus, the material used as the resonator 14 is usually dictated, at least in part, by the nature of the cleaning fluid. Sapphire is a desirable material for the resonator 14 when the items to be cleaned by the transducer 10 require parts per trillion purity. For example, semiconductor wafers require this type of purity. A hydrofluoric acid (HF) based cleaning fluid might be used in a cleaning process of this type for semiconductor wafers.

The resonator 14 has a height "k". Generally, the height "k" is chosen so as to minimize reflectance of acoustic energy, such as by making "k" a multiple of one-half of the wavelength of the acoustic energy emitted by the crystal 24.

In addition to the layers shown in Fig. 3, it should be appreciated that there are many ways of connecting the resonator 14 to the crystal 24. For example, the resonator 14 may be connected to the crystal 24 using a combination layer in place of the layers 76 and 78. In this embodiment, the combination layer is a conductive silver emulsion (paste) that is applied to the resonator 14. An acceptable emulsion is the commercially available product referred to as the 2617D low temperature silver conductor, available from EMCA-REMAX Products, of Montgomeryville, Pennsylvania. The layer 140 is applied directly to the resonator 14 using screen printing techniques. In this embodiment, a region of the combination layer would be used in the step region 27 (shown in Fig. 1) to contact the spring connector 26.

In another embodiment, the resonator 14 is connected to the crystal 24 using epoxy. The epoxy is used in the bonding layer 70 in place of the solder-like materials described previously. The epoxy may comprise any suitable electrically conductive epoxy.

The transducer 10 is designed to deliver an approximately uniform amount of acoustic energy to each unit of surface area of a rotating substrate in a given time period. Typically, the substrate is circular in shape, such as the surface of a semiconductor wafer, so the intensity (energy/unit time) of the acoustic energy experienced by the substrate when it is rotating, varies in a direction which corresponds to the radius of the circular region. Therefore, in order for the transducer 10 to deliver a uniform amount of acoustic energy to each unit of surface area of the substrate in a given time period, the transducer 10 must emit a variable intensity field of acoustic energy. In general, the variable intensity field is obtained using one of four different methods. In a first method, the crystal 24 is shaped to deliver the variable intensity field. In a second method, the electrode layers on the surfaces of the crystal 24 are shaped to deliver the desired variable intensity field. In a third method, segments of the crystal 24 are driven at different power levels to deliver the desired variable intensity field. In a fourth method, combinations of methods one through three are used to deliver the desired variable intensity field.

Fig. 4 illustrates the first method. In Fig. 4, the crystal 24 has a wedge shape 90. The wedge shape 90 comprises a curved side 92, a blunt side 94, a first tapered side 96 and a second tapered side 98. The wedge shape 90 has a wide end 100 adjacent to the curved side 92 and a narrow end 102 adjacent to the blunt side 94. An angle θ is formed between the sides 96 and 98. The wedge shape 90 is useful in situations where the transducer 10 needs to deliver an approximately equal amount of energy to each unit area on the circular surface of a rotating object in a given amount of time without using a transducer that covers the whole surface area of the object. Generally the wedge shape 90 covers forty percent or less of the surface area of the object.

For example, in Fig. 5 an object 103, having a circular surface 104 is rotated underneath the transducer 10 at a constant rate. A center point 106 represents the center of the surface 104. The wedge shape 90 of the crystal 24 will deliver a uniform field of acoustic energy having variable intensity along a radius 108 when the surface 104 rotates underneath the wedge shape 90 (i.e. underneath the crystal 24). The intensity varies because the narrow end 102 of the wedge shape 90 delivers a smaller amount of energy to the surface 104 than will the wide end 100. This is because the power (energy/cm²) transmitted by the transducer 10 is uniform but the surface area of the wide end 100 is greater than the surface area of the narrow end 102. When the object 103 is rotating, a first unit of surface area on the surface 104 that is rotating underneath the wide end 100 receives the same amount of energy from the wide end as a second unit of surface area that is rotating underneath the narrow end 102, even though the first unit of surface area is moving with a greater linear velocity. With respect to rotation, it should be noted that the object 103 could be held stationary and the transducer 10 could be rotated. It is the relative motion between the object 103 and the transducer 10 that matters.

In Fig. 5, a plurality of regions 112, 114, 116 and 118 on the surface 104 are illustrated. The regions 112, 114, 116 and 118 all have the same area. Because the region 112 is positioned at a larger radius from the center point 106 than the region 118, the region 112 will pass underneath the transducer 10 with a greater linear velocity than the region 118 when the object 103 is rotating. Since it is desired to have the transducer 10 deliver an equal amount of acoustic energy to the regions 112 and 114 per unit time, the total output from the transducer 10 must vary along the radius 108. If the transducer 10 has a uniform power output (watts/unit area), then increasing the surface area of the crystal 24 in the radial direction (moving from the center point 106 outwards) will give the desired increase in total energy output from the transducer. The wedge shape 90 illustrates this configuration.

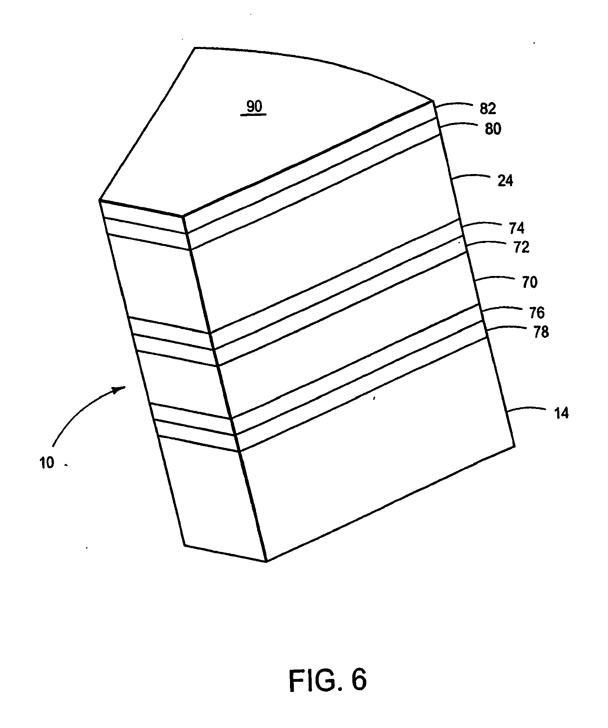

Fig. 6 illustrates an embodiment of the transducer 10 where each of the layers shown in Fig. 3 have the wedge shape 90. Specifically, the third adhesion layer 80, the metal layer 82, the crystal 24, the first adhesion layer 74, the first wetting layer 72, the bonding layer 70, the second wetting layer 76, the second adhesion layer 78 and the resonator 14 all have the wedge shape 90. However, such a configuration is not required to achieve the effect of variable intensity along the radial direction. The only layer that must have the wedge shape 90 is the crystal 24. The other layers and the resonator 14 could have different shapes provided that they at least completely cover the crystal 24.

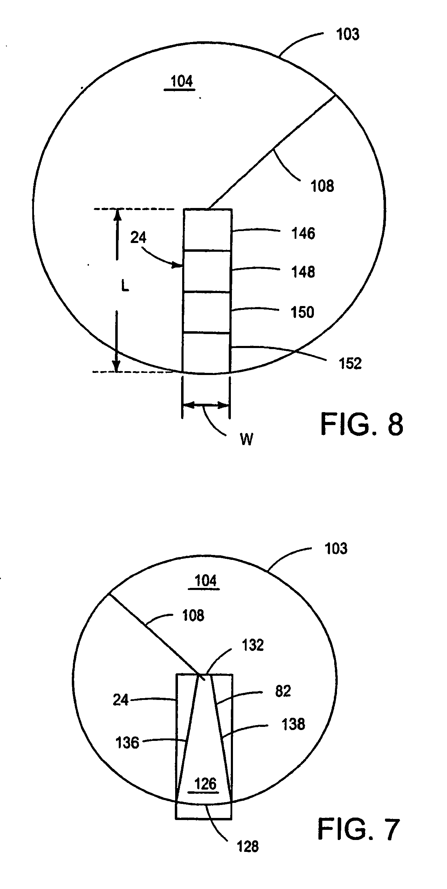

Fig. 7 illustrates the second embodiment of the transducer 10 that delivers a uniform amount of acoustic energy to each unit of surface area on a rotating substrate in a given time period. In Fig. 7, elements that are identical to elements described previously are represented by the same identifying numbers. In Fig. 7, the crystal 24 is rectangular in shape. The metal layer 82 has a wedge shape 126. Additionally, any other electrically conductive layers between the crystal 24 and the metal layer 82, such as the layer 80 if it is used, should have the wedge shape 126. The wedge shape 126 is the same shape as the wedge shape 90 shown in Fig. 4 and comprises a curved side 128, a blunt side 132, a first tapered side 136 and a second tapered side 138. As was described previously in Fig. 5, an object 103 having a circular surface 104, is rotated underneath the transducer 10 at a constant rate in Fig. 7. Alternatively, the transducer 10 could be rotated at a constant rate relative to the object 103.

The result of giving the metal layer 82 the wedge shape 126 is the same as giving the crystal 24 the wedge shape 90. This is because the crystal 24 only emits acoustic energy from the area that is excited with an electric field. In the transducer 10, the electric field is supplied by the potential difference that exists between the metal layer 82 and the first wetting layer 72 when the RF voltage is applied to the spring connectors 22 and 26, as is explained below. Hence, when the metal layer 82 has the wedge shape 126 and covers the crystal 24, the acoustic energy emitted from the crystal 24 has a variable intensity along the radius 108 when the surface 104 rotates underneath the wedge shape 126 (i.e. underneath the crystal 24). Preferably, the first wetting layer 72 and any other electrically conductive layers between the bonding layer 70 and the crystal 24, such as the layer 74, also have the wedge shape 126.

Applying the metal layer 82 to the crystal 24 in the wedge shape 126 is accomplished as follows. The crystal 24 is masked with an inert material, such as Kapton® tape, so that a region of the crystal 24 having the wedge shape 126 is not covered by the mask. Then the metal layer 82 deposited by using a physical vapor deposition (PVD) technique, such as argon sputtering. Generally, the crystal 24 is masked before the wetting layer 80 is sputtered on, so that both the wetting layer 80 and the metal layer 82 have the wedge shape 126. Other techniques such as a plating technique can also be used to deposit the metal layer 82. Preferably, the metal layer comprises silver, but other conductive materials can be used. The same masking technique is used for giving the layers 72 and 74 the wedge shape 126.

The power for driving the crystal 24 is provided by a radiofrequency (RF) generator (not shown), such as a 1000 watt RF generator. Preferably, the RF voltage applied to the crystal has a frequency in the range of approximately 925 KHz. However, RF voltages in the range of approximately 0.4 to 2.0 MHz can be used. The RF power is delivered to the transducer 10 through a coaxial cable that connects to a standard BNC connector that fits in a threaded aperture 28. The RF voltage is delivered to the crystal 24 by the first spring connectors 22 and one or more of the second spring connectors 26. The BNC connector is electrically connected to the printed circuit board PCB 25 which allows the RF voltage to be delivered to the connectors 22 and 26.

The second spring connectors 26 provide an electrical connection between the PCB 58 and the layer 76 (shown in Fig. 3). The first spring connectors 54 provide an electrical connection between the PCB 58 and the layer 82 (shown in Fig. 3) on the crystal 24. With this arrangement, the plurality of first spring connectors 22 provide the active connection to the RF generator and the second spring connectors 26 provide the ground connection to the RF generator.

The transducer 10 includes the step-region 27. The step region 27 is an electrically conductive region on the resonator 14, such as the layer 76, that can be contacted by the second spring connector 26. Since all of the layers between the layer 76 and the crystal 24 are electrically conductive (i.e. the layers 70, 72 and 74), contact with the step region 27 is electrically equivalent to contact with the surface of the crystal 24 that is adjacent to the resonator 14. The first spring connectors 22 make electrical contact with the metal layer 82 to complete the circuit for driving the crystal 24.

Fig. 8 illustrates the third example of the transducer 10 that delivers an approximately uniform amount of acoustic energy to each unit of surface area on a rotating substrate in a given time period. This example does not have a wedge-shape, and so does not fall within the scope of the claims. In Fig. 8, elements that are identical to elements described previously are represented by the same identifying numbers. In Fig. 8, the crystal 24 is rectangular in shape and has a length "L" and a width "w". Generally, the length "L" is equal to the radius 108, but the length "L" may be slightly longer than the radius 108 to ensure complete coverage of the surface 104. The crystal 24 is divided into a plurality of segments, such as a segment 146, a segment 148, a segment 150 and a segment 152. Each of the segments 146, 148, 150 and 152 comprise a separate piece of the crystal 24. In other words, the crystal 24 has been cut into four separate pieces which function as the segments 146, 148, 150 and 152. Each of the segments 146, 148, 150 and 152 are attached to the resonator 14 by a separate set of attachment layers, such as the layers illustrated in Fig. 3, so that the segments do not short circuit or electrically couple. Each of the segments 146, 148, 150 and 152 have separate electrical connections to the RF generator, such as by using separate spring connectors 22 for each segment. In this embodiment, the resonator 14 (shown in Fig. 3) is still one continuous piece.

In the example illustrated in Fig. 8, the use of separately controllable segments allows the transducer 10 to be used in several ways. First, each of the segments146, 148, 150 and 152 can have equal areas and be driven at a different power (watts/cm²). The segment 152 is driven at a greater power than the segment 150. The segment 150 is driven at a greater power than the segment 148, and the segment 148 is driven at a greater power than the segment 146. The increase in power with increasing radius means that a unit of surface area on the surface 104 that passes under the segment 152 will receive the same total amount of energy as an equal unit of surface area that passes under the segment 146, even though the two units are not underneath the crystal 24 for the same amount of time. Additionally, the time that each of the segments 146, 148, 150 and 152 is on can be varied.

A second way that the transducer 10 can be used with separately controllable segments is to make the areas of the segments 146, 148, 150 and 152 different and drive each segment at a different power for a variable amount of time.

An alternate design for the example illustrated in Fig. 8 is to leave the crystal 24 as one continuous piece, but to divide the metal layer 82 into separate segments analogous to the segments 146,148, 150 and 152. The segmentation of the metal layer 82 is accomplished using the same technique that was described previously with respect to Fig. 7, for creating the wedge shape 126. The segmentation of the metal layer allows the crystal 24 to be driven at different power levels along its length for variable lengths of time in the same way that was described previously with respect to Fig. 8.

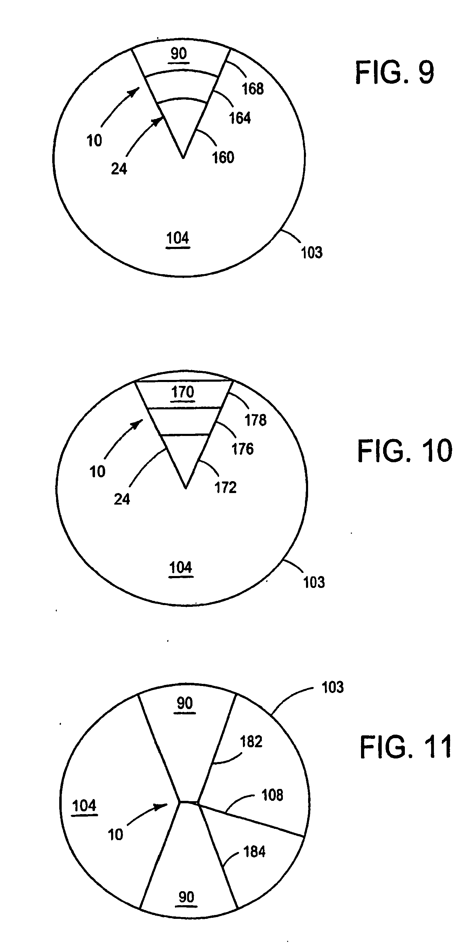

Fig. 9 illustrates the fourth embodiment of the transducer 10 that delivers a uniform amount of acoustic energy to each unit of surface area on a rotating substrate in a given time period. In Fig. 9, elements that are identical to elements described previously are represented by the same identifying numbers. In Fig. 9, the crystal 24 has the wedge shape 90 described previously with respect to Fig. 4. The crystal 24 is also divided into a plurality of segments, such as a segment 160, a segment 164 and a segment 168. Each of the segments 160, 164 and 168 comprise a separate piece of the crystal 24, with each segment having the same area. The reason for combining the techniques of using the wedge shape 90 with the technique of segmenting the crystal 24 is that this allows a greater degree of control over delivering a uniform amount of acoustic energy to each unit of surface area on the rotating surface 104 in a given time period.

Each of the segments 160, 164 and 168 are attached to the resonator 14 by a separate set of attachment layers, such as the layers illustrated in Fig. 3, so that the segments do not short circuit or electrically couple. Each of the segments 160, 164 and 168 have separate electrical connections to the RF generator, such as by using separate spring connectors 22 for each segment. In this embodiment, the resonator 14 (shown in Fig. 3) is still one continuous piece.

In the embodiment illustrated in Fig. 9, the use of separately controllable segments allows the transducer 10 to be used in several ways. First, each of the segments 160, 164 and 168 can be driven at a different power (watts/cm²), as was described previously with respect to Fig. 8, with the segment 168 being driven at higher power than the segment 160. The increase in power with increasing radius means that a unit of surface area on the surface 104 that passes under the segment 152 will receive the same total amount of energy as an equal unit of surface area that passes under the segment 146, even though the two units are not underneath the crystal 24 for the same amount of time. Each of the segments 160, 164 and 168 can be active for the same amount of time, or for a variable amount of time. Furthermore, each segment can be on or off at different times.

Second, each of the segments 160, 164 and 168 can be driven at the same power. However, in this embodiment the length of time that power is supplied to each segment is different. In a third use, each of the segments 160, 164 and 168 are driven at the same power, but the sequence of when a particular segment is on is varied. Usually no two segments are on at the same time, but when a segment is on, it is on for the same length of time as another segment.

An alternate design for the embodiment illustrated in Fig. 9 is to leave the crystal 24 as one continuous piece, but to divide the metal layer 82 into separate segments analogous to the segments 160,164 and 168. The segmentation of the metal layer 82 is accomplished using the same technique that was described previously with respect to Figs. 7 and 8. The segmentation of the metal layer allows the crystal 24 to be driven at different power levels and times along its length in the same way that was described previously with respect to Fig. 9.

Fig. 10 illustrates a variation of the embodiment shown in Fig. 9 where the crystal 24 has a triangular shape 170 instead of the wedge shape 90. The crystal 24 is divided into a plurality of segments, such as a segment 172, a segment 176 and a segment 178. Each of the segments 172, 176 and 178 comprise a separate piece of the crystal 24, with each segment having the same area. The reason for combining the techniques of using the wedge shape 90 with the technique of segmenting the crystal 24 is that this allows a greater degree of control over delivering a uniform amount of acoustic energy to each unit of surface area on the rotating surface 104 in a given time period.

Each of the segments 172, 176 and 178 are attached to the resonator 14 by a separate set of attachment layers, and have separate electrical connections to the RF generator, as was described previously with respect to Fig. 9. This permits the segments 172, 176 and 178 to be driven at a different power (watts/cm²) levels for different lengths of time, as was described previously with respect to Fig. 9. Also, an alternate design for the embodiment illustrated in Fig. 10 is to leave the crystal 24 as one continuous piece, but to divide the metal layer 82 into separate segments analogous to the segments 172, 176 and 178, as was described previously with respect to Fig. 9.

Fig. 11 illustrates a variation of the transducer 10 described previously with respect to Fig. 4. In Fig. 11, elements that are identical to elements described previously are represented by the same identifying numbers. Fig. 11 illustrates that the transducer 10 can be comprised of a first crystal 182 having the wedge shape 90 and a second crystal 184 having the wedge shape 90. In this embodiment, the transducer 10 extends across the diameter of the surface 104. Each of the crystals 182 and 184 are attached to the resonator 14 as was described previously with respect to Fig. 4, and function in the same way. The crystals 182 and 184 could be rectangular in shape and the wedge shape 90 could be imparted by giving the layers 82 and 76 the wedge shape 90, as was described previously with respect to Fig. 7. Similarly, the crystals 182 and 184 could be segmented as described previously with respect to Figs. 9 and 10.

From the discussion of Figs. 4, 8, 9, 10 and 11, it should be clear that other shapes besides the wedge shape 90, rectangles and triangles can be used with the radial power transducer 10. In general, however the transducer 10 covers forty percent or less of the surface area of the object 103.

Another parameter that can be varied so that the transducer 10 delivers a uniform amount of acoustic energy to each unit of surface area of a rotating substrate in a given time period, is the thickness of the bonding layer 70 shown in Fig. 3. By varying the thickness of the layer 70 along the direction of the radius 108, the power emitted by the transducer 10 changes. It is thought that this phenomenon results from different reflection characteristics of the acoustic energy as the layer thickness changes.

It is clear that the transducer 10 can be formed in many ways. Stated generally, the transducer comprises an acoustic energy generating means for generating acoustic energy in the frequency range of 0.4 to 2.0 MHz. The acoustic energy generating means delivers an approximately uniform amount of acoustic energy to each unit of surface area on a rotating substrate in a given time period and has a surface area that is less than the surface area of the substrate. A resonator is attached to the acoustic energy generating means for transmitting the acoustic energy to the substrate through the liquid used in the cleaning process. The acoustic energy generating means may take many forms, including the wedge shaped crystal shown in Figs. 4-6 and 11, the rectangular crystal with wedge shaped electrodes shown in Fig. 7, the rectangular crystal with separately controllable segments shown in Fig. 8, or the wedge shaped crystal with separately controllable segments shown in Figs. 9 and 10.

The transducer 10 is used in megasonic cleaning processes (or other processes where a liquid chemical is applied to the surface of the substrate), where an approximately equal amount of acoustic energy must be delivered to each unit of surface area on the rotating substrate in a given time period to assist in the cleaning or chemical process. The transducer 10 is especially useful for cleaning individual items that are difficult to clean in a batch process. Such items include large semiconductor wafers, semiconductor wafers from a low production run, such as for custom made or experimental chips, flat panel displays, and other large flat substrates.

The cleaning process for cleaning individual items of this type involves applying a cleaning or process fluid to the surface of the object and then rotating the object underneath the transducer 10. Acoustic energy emitted from the resonator 14 is transmitted into the process fluid and causes cleaning to occur. In alternate methods, the transducer 10 can be rotated and the object held stationary, or both can be rotated.

In practice, different process fluids are used for different cleaning tasks. The exact composition of many process fluids is proprietary to the companies that manufacture the fluids. However, typical process fluids include distilled water, aqueous solutions of ammonium hydroxide, hydrogen peroxide, hydrochloric acid, nitric acid, acetic acid, or hydrofluoric acid, and combinations of these reagents. Commonly used process fluid compositions are referred to as SC-1 and SC-2.

The reason an approximately equal amount of acoustic energy must be delivered to each unit of surface area on a rotating substrate in a given time period is that the effectiveness of the cleaning or chemical process varies with the amount of acoustic energy that is transmitted into the fluid. Therefore, if different areas on the surface of a wafer receive different amounts of acoustic energy, the degree of cleaning may vary. This is particularly true in cases where the chemistry of the process fluid is assisting in the cleaning action. In such situations, the use of the transducer 10 is desirable.

Although the present invention has been described in terms of the presently preferred embodiments, it is to be understood that such disclosure is not to be interpreted as limiting. Various alterations and modifications will no doubt become apparent to those skilled in the art after having read the above disclosure.

## Claims

1. A transducer (10) comprising:
an acoustic energy generating means for generating acoustic energy, the acoustic energy generating means being adapted for delivering a uniform amount of acoustic energy in a given time period to each unit of surface area on a particular surface (104) of a substrate (103) to be exposed to the acoustic energy when a relative rotational motion exists between the substrate (103) and the transducer (10), the acoustic energy generating means including a wedge shaped design feature that delivers a variable amount of acoustic energy from the acoustic energy generating means to compensate for an increase in linear velocity caused by the relative rotational motion for points on the particular surface (104) at increasing distance from a centre of the particular surface (104), the acoustic energy generating means overlying less than one hundred percent of the particular surface (104); and
a resonator (14) attached to the acoustic energy generating means for transmitting the acoustic energy to the substrate (103).

2. The transducer (10) of Claim 1, wherein the acoustic energy generating means comprises a piezoelectric crystal (24) having the wedge shape design feature in which a first end of the piezoelectric crystal (24) is wider than a second end of the piezoelectric crystal (24).

3. The transducer (10) of Claim 2, wherein the piezoelectric crystal (24) has a planar surface comprised of a first side (96), a second side (98), a narrow end (94) and a wide end (92), with an angle (θ) separating the first side (96) from the second side (98), and the angle (θ) chosen so that the piezoelectric crystal (24) overlies forty percent or less of the particular surface (104).

4. The transducer (10) of claim 1, wherein the acoustic energy generating means comprises an assembly comprised of two or more piezoelectric crystal (24) segments, the assembly having the wedge shaped design feature in which a first end of the assembly is wider than a second end of the assembly.

5. The transducer (10) of claim 1, wherein the acoustic energy generating means comprises a piezoelectric crystal (24) having at least one electrode, the at least one electrode having the wedge shaped design feature in which a first end of the electrode is wider than a second end of the electrode.

6. The transducer (10) of any one of the preceding claims, wherein the resonator (14) comprises a material selected from the group consisting of quartz, sapphire, silicon carbide, silicon nitride, ceramics, aluminium and stainless steel.

7. The transducer (10) of any one of the preceding claims, further comprising:
an attachment layer (70) positioned between the acoustic energy generating means and the resonator (14) for attaching the resonator (14) to the acoustic energy generating means.

8. The transducer (10) of Claim 7, wherein the attachment layer comprises a material selected from the group consisting of indium, tin, indium alloys and tin alloys.

9. The transducer (10) of Claim 7, wherein the attachment layer comprises epoxy.

10. The transducer (10) according to any one of the preceding claims, wherein the acoustic energy generating means is provided for generating acoustic energy in the frequency range of 0.4 to 2.0 MHz.

11. A method of treating a substrate (103) including the step of providing a transducer (10) according to any one of the preceding claims, and using the transducer (10) to apply a generally uniform amount of acoustic energy in a given time period to each unit of surface area of the substrate (103) when a relative rotational movement exists between the substrate (103) and the transducer (10), wherein the substrate (103) comprises a semiconductor wafer.

## Patentansprüche

1. Wandler (10), der Folgendes umfasst:
eine akustische Energie erzeugende Einrichtung zum Erzeugen akustischer Energie, wobei die akustische Energie erzeugende Einrichtung zum Liefern einer einheitlichen Menge akustischer Energie in einem bestimmten Zeitabschnitt an jede Oberflächeneinheit an einer jeweiligen Oberfläche (104) eines Substrats (103) ausgeführt ist, die der akustischen Energie ausgesetzt werden soll, wenn eine relative Drehbewegung zwischen dem Substrat (103) und dem Wandler (10) besteht, wobei die akustische Energie erzeugende Einrichtung ein keilförmiges Konstruktionsmerkmal aufweist, das eine variable Menge akustischer Energie von der akustische Energie erzeugenden Einrichtung liefert, um eine durch die relative Drehbewegung bedingte Erhöhung der linearen Geschwindigkeit für Punkte an der jeweiligen Oberfläche (104) mit zunehmendem Abstand von einer Mitte der jeweiligen Oberfläche (104) auszugleichen, wobei die akustische Energie erzeugende Einrichtung weniger als einhundert Prozent der jeweiligen Oberfläche (104) überlagert, und
einen an der akustische Energie erzeugenden Einrichtung angebrachten Resonator (14) zum Übertragen der akustischen Energie auf das Substrat (103).

2. Wandler (10) nach Anspruch 1, bei dem die akustische Energie erzeugende Einrichtung einen piezoelektrischen Kristall (24) aufweist, der das keilförmige Konstruktionsmerkmal hat, bei dem ein erstes Ende des piezoelektrischen Kristalls (24) breiter als ein zweites Ende des piezoelektrischen Kristalls (24) ist.

3. Wandler (10) nach Anspruch 2, bei dem der piezoelektrische Kristall (24) eine ebene Oberfläche hat, die aus einer ersten Seite (96), einer zweiten Seite (98), einem schmalen Ende (94) und einem breiten Ende (92) besteht, wobei ein Winkel (θ) die erste Seite (96) von der zweiten Seite (98) trennt und der Winkel (θ) so gewählt ist, dass der piezoelektrische Kristall (24) vierzig Prozent oder weniger der jeweiligen Oberfläche (104) überlagert.

4. Wandler (10) nach Anspruch 1, bei dem die akustische Energie erzeugende Einrichtung eine Anordnung umfasst, die zwei oder mehr Segmente aus piezoelektrischem Kristall (24) beinhaltet, wobei die Anordnung das keilförmige Konstruktionsmerkmal hat, bei dem ein erstes Ende der Anordnung breiter als ein zweites Ende der Anordnung ist.

5. Wandler (10) nach Anspruch 1, bei dem die akustische Energie erzeugende Einrichtung einen piezolelektrischen Kristall (24) beinhaltet, der wenigstens eine Elektrode hat, wobei die wenigstens eine Elektrode das keilförmige Konstruktionsmerkmal hat, bei dem ein erstes Ende der Elektrode breiter als ein zweites Ende der Elektrode ist.

6. Wandler (10) nach einem der vorhergehenden Ansprüche, bei dem der Resonator (14) ein aus der Gruppe bestehend aus Quarz, Saphir, Siliciumcarbid, Siliciumnitrid, Keramik, Aluminium und rostfreiem Stahl ausgewähltes Material beinhaltet.

7. Wandler (10) nach einem der vorhergehenden Ansprüche, der ferner Folgendes aufweist:
eine Anbringungsschicht (70), die zum Anbringen des Resonators (14) an der akustischen Energie erzeugenden Einrichtung zwischen der akustische Energie erzeugenden Einrichtung und dem Resonator (14) positioniert ist.

8. Wandler (10) nach Anspruch 7, bei dem die Anbringungsschicht ein aus der Gruppe bestehend aus Indium, Zinn, Indiumlegierungen und Zinnlegierungen ausgewähltes Material beinhaltet.

9. Wandler (10) nach Anspruch 7, bei dem die Anbringungsschicht Epoxidharz beinhaltet.

10. Wandler (10) nach einem der vorhergehenden Ansprüche, bei dem die akustische Energie erzeugende Einrichtung zum Erzeugen von akustischer Energie im Frequenzbereich von 0,4 bis 2,0 MHz vorgesehen ist.

11. Verfahren zum Behandeln eines Substrats (103), das den Schritt des Bereitstellens eines Wandlers (10) nach einem der vorhergehenden Ansprüche und des Verwendens des Wandlers (10) zum Anwenden einer allgemein einheitlichen Menge akustischer Energie in einem bestimmten Zeitabschnitt auf jede Oberflächeneinheit des Substrats (103), wenn eine relative Drehbewegung zwischen dem Substrat (103) und dem Wandler (10) besteht, wobei das Substrat (103) einen Halbleiter-Wafer umfasst.

## Revendications

1. Transducteur (10) comprenant:
un moyen de génération d'énergie acoustique pour générer une énergie acoustique, le moyen de génération d'énergie acoustique étant adapté pour délivrer une quantité uniforme d'énergie acoustique dans une période de temps donnée à chaque unité de superficie sur une surface particulière (104) d'un substrat (103) à exposer à l'énergie acoustique quand un mouvement de rotation relatif existe entre le substrat (103) et le transducteur (10), le moyen de génération d'énergie acoustique comportant une caractéristique de conception en forme de coin qui délivre une quantité variable d'énergie acoustique à partir du moyen de génération d'énergie acoustique pour compenser une augmentation de vitesse linéaire causée par le mouvement de rotation relatif de points sur la surface particulière (104) situés à une distance croissante depuis un centre de la surface particulière (104), le moyen de génération d'énergie acoustique recouvrant moins que cent pour cent de la surface particulière (104) ; et
un résonateur (14) fixé au moyen de génération d'énergie acoustique pour transmettre l'énergie acoustique au substrat (103).

2. Transducteur (10) selon la revendication 1, dans lequel le moyen de génération d'énergie acoustique comprend un quartz piézoélectrique (24) ayant la caractéristique de conception en forme de coin dans laquelle une première extrémité du quartz piézoélectrique (24) est plus large qu'une seconde extrémité du quartz piézoélectrique (24).

3. Transducteur (10) selon la revendication 2, dans lequel le quartz piézoélectrique (24) a une surface plane composée d'un premier côté (96), d'un second côté (98), d'une extrémité étroite (94) et d'une extrémité large (92), un angle (θ) séparant le premier côté (96) du second côté (98), et l'angle (θ) étant choisi de telle sorte que le quartz piézoélectrique (24) recouvre quarante pour cent ou moins de la surface particulière (104).

4. Transducteur (10) selon la revendication 1, dans lequel le moyen de génération d'énergie acoustique comprend un ensemble composé de deux ou plusieurs segments de quartz piézoélectrique (24), l'ensemble ayant la caractéristique de conception en forme de coin dans laquelle une première extrémité de l'ensemble est plus large qu'une seconde extrémité de l'ensemble.

5. Transducteur (10) selon la revendication 1, dans lequel le moyen de génération d'énergie acoustique comprend un quartz piézoélectrique (24) ayant au moins une électrode, l'au moins une électrode ayant la caractéristique de conception en forme de coin dans laquelle une première extrémité de l'électrode est plus large qu'une seconde extrémité de l'électrode.

6. Transducteur (10) selon l'une quelconque des revendications , dans lequel le résonateur (14) comprend un matériau sélectionné dans le groupe consistant en quartz, saphir, carbure de silicium, nitrure de silicium, céramique, aluminium et acier inoxydable.

7. Transducteur (10) selon l'une quelconque des revendications précédentes, comprenant en outre :
une couche de fixation (70) positionnée entre le moyen de génération d'énergie acoustique et le résonateur (14) pour fixer le résonateur (14) au moyen de génération d'énergie acoustique.

8. Transducteur (10) selon la revendication 7, dans lequel la couche de fixation comprend un matériau sélectionné dans le groupe consistant en indium, étain, alliages d'indium et alliages d'étain.

9. Transducteur (10) selon la revendication 7, dans lequel la couche de fixation comprend de l'époxy.

10. Transducteur (10) selon l'une quelconque des revendications précédentes, dans lequel le moyen de génération d'énergie acoustique est fourni pour générer une énergie acoustique dans la gamme de fréquences de 0,4 à 2,0 MHz.

11. Procédé de traitement d'un substrat (103) comportant l'étape de fourniture d'un transducteur (10) selon l'une quelconque des revendications précédentes, et l'utilisation du transducteur (10) pour appliquer une quantité généralement uniforme d'énergie acoustique dans une période de temps donnée à chaque unité de superficie du substrat (103) quand un mouvement de rotation relatif existe entre le substrat (103) et le transducteur (10), le substrat (103) comprenant une tranche semi-conductrice.
